# DEMANDE DE BREVET EUROPEEN

(11) **EP 1 845 617 A1**
(43) Date de publication de la demande: **17.10.2007**
(21) Numéro de dépôt: 07368006.8
(22) Date de dépôt: 10.04.2007
(51) Int. Cl.: H03K 3/356

(54) **Bascule de type D pour circuit haute fréquence**

(30) Priorité: 10.04.2006 FR 0603137
(71) Demandeur: STMicroelectronics S.A., 92120 Montrouge (FR)
(72) Inventeur: Sie, Mathilde, 31500 Toulouse (FR)
(74) Mandataire: Schuffenecker, Thierry

(57) **Abrégé**

1. Circuit de bascule statique de type D, comportant:
- un premier circuit connecté entre un premier potentiel de référence et un second potentiel de référence, et comportant en outre, en série, un premier transistor (41), un second transistor (51) et un troisième transistor (61) ;
- un second circuit connecté entre le premier et le second potentiel, et comportant en outre en série un quatrième transistor (42), un cinquième transistor (52) et un sixième transistor (62) ;
- un troisième circuit comportant un septième transistor (71) et un huitième transistor (72) connectés en série entre, d'une part, le point de jonction du second transistor (51) et du troisième transistor (61) et, d'autre part, le point de jonction du cinquième transistor (52) et du sixième transistor (62), ledit point de jonction des transistors (71) et (72) étant connecté au potentiel Vdd. La donnée D est transmise via une première entrée aux grilles des troisième et septième transistors (61,71).

La donnée opposée de D est transmise via une seconde entrée aux grilles du sixième transistor (62) et du huitième transistor (72). Le signal d'horloge est transmis aux grilles des second et cinquième transistors (51, 52).

La sortie Q de la bascule est générée au point de jonction des quatrième et cinquième transistors (42,52), également connectés à la grille du premier transistor (41). La sortie inverse Q est générée au point de jonction des premier et second transistors (41,51), également connectés à la grille du quatrième transistor (42).

## Description

### Domaine technique de l'invention

La présente invention concerne le domaine des circuits électroniques et notamment une bascule de type D statique.

### Etat de la technique

La bascule de type D réagissant sur niveau (ou *D-Latch* dans la littérature anglo-saxonne) est un circuit extrêmement populaire dans la conception des circuits électroniques. Elle sert depuis le début de l'ère de l'électronique à concevoir toutes sortes de circuits plus complexes, et notamment la très classique bascule D statique réagissant sur front (ou D *flip-flop* dans la littérature anglo-saxonne), mais également les diviseurs de fréquence.

Avec l'accroissement de la fréquence de fonctionnement des circuits électroniques, et notamment des circuits utilisés dans le domaine des télécommunications, il n'est plus rare d'envisager des fréquences de fonctionnement de l'ordre de 10 GHz.

De telles fréquences de fonctionnement constituent un obstacle de taille pour le concepteur de circuits électroniques qui dispose des bascules classiques et bien connues.

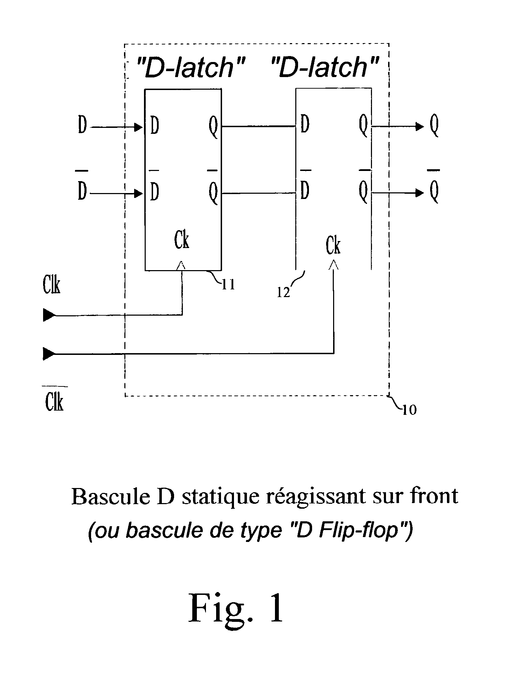

La figure 1 illustre une structure bien connue d'une D *flip-flop* 10 réalisée au moyen de deux *D Latches,* respectivement 11 et 12, connectées en maître-esclave. Il est à noter que l'implémentation concrète de chacune des bascules D 11 et 12 sera fonction de la fréquence de fonctionnement considérée.

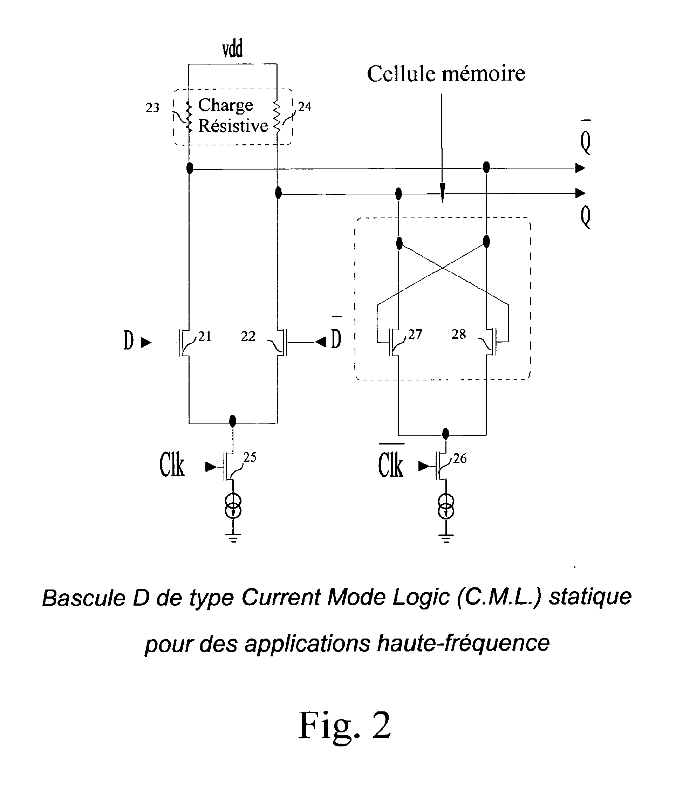

Un exemple d'implémentation de chacune des bascules 11 ou 12 - adaptée à un fonctionnement à plusieurs giga-hertz, est illustrée dans le circuit de la figure 2. On désigne une telle bascule par l'appellation « statique » qui signifie que cette bascule est capable de maintenir l'information un temps indéfini grâce à un point mémoire, qui ne dépend pas de la fréquence de fonctionnement.

Comme on le voit, cette bascule comporte une structure différentielle composée de transistors MOS fonctionnant en régime saturé avec de faibles amplitudes sur les signaux d'entrées et de sorties (entre 200 et 400 mV). Cette structure fait commuter le courant d'une branche à l'autre de la structure différentielle, d'où le nom de son mode de fonctionnement que l'on désigne souvent sous l'appellation « en courant » (ou *Current Mode Logic* dans la littérature anglo-saxonne). La structure différentielle comporte les transistors MOS 21 et 22 disposant chacun d'une charge résistive, respectivement 23 et 24. La cellule mémoire comporte des transistors MOS 27 et 28 et les deux signaux d'horloge (vraie et inverse) sont transmis à la bascule via des transistors 25 et 26.

Le fonctionnement à faible amplitude de la structure différentielle statique permet une montée en fréquence élevée. En revanche, on constate que son immunité au bruit est très faible du fait de l'utilisation de signaux de faible amplitude et de charges résistives 23 et 24 qui introduisent un bruit thermique non négligeable.

D'autre part, il est difficile d'implémenter ce type de bascule dans des circuits fonctionnant avec des signaux « pleine échelle » (ce qui signifie que ce sont des signaux dont l'excursion est maximale, c'est-à-dire entre l'alimentation et la masse du circuit) utilisés dans les circuits réalisés en logique CMOS. Si les concepteurs les intègrent malgré tout, ils devront réaliser les interfaces entre ces bascules CML et le reste des circuits CMOS : durant la conception, ces interfaces deviennent à leurs tours des points bloquants en terme de rapidité de fonctionnement.

Enfin, ce premier circuit connu présente l'inconvénient d'une consommation importante, ce qui le rend peu apte à son intégration dans des circuits de l'électronique portable.

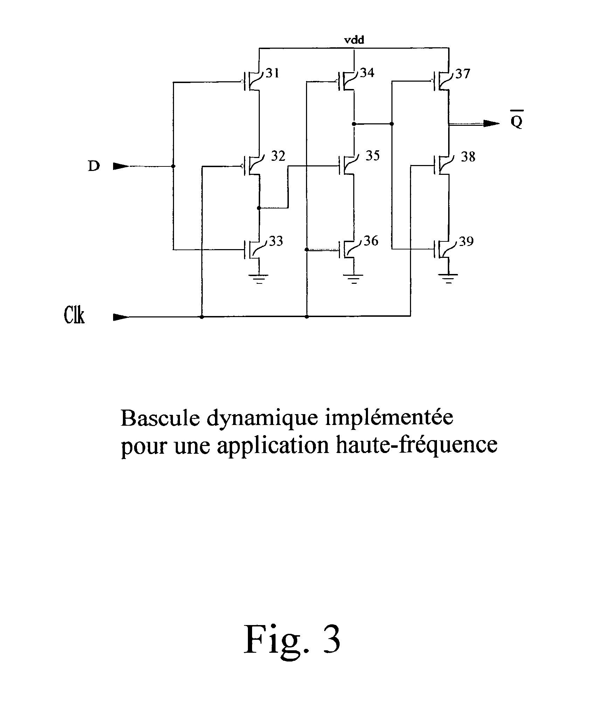

La figure 3 illustre une autre implémentation bien connue d'une bascule D permettant une fréquence de fonctionnement élevée. Il s'agit de la bascule D de type *dynamique* basée sur les transistors 31 à 39, dans laquelle on vient stocker l'information dans la capacité de jonction de transistors MOS, information qui doit être périodiquement rafraîchie.

Ce second circuit présente l'avantage, par rapport au premier circuit connu évoqué précédemment, de réduire le bruit de phase ainsi que la consommation en courant, et d'utiliser des signaux pleine échelle. En revanche, cette bascule D dynamique requiert un paramétrage pour dimensionner les capacités internes des transistors MOS à la fréquence de fonctionnement souhaitée. On comprend aisément que plus la fréquence de fonctionnement choisie est élevée, et plus il faudra réduire la capacité des transistors MOS dans laquelle on vient charger l'information à stocker afin de permettre le fonctionnement à fréquence élevée. Cette bascule D dynamique ne saurait par conséquent être une bascule « large bande » car elle ne permet un fonctionnement que dans une plage de fréquences relativement étroite. D'autre part, ce n'est pas une structure différentielle, et donc symétrique, fonctionnant avec des signaux complémentaires en entrée et en sortie mais c'est une struture dissymétrique. De ce fait, et il s'agit d'un inconvénient important, on observe que la bascule D dynamique est fragile et particulièrement sensible au procédé de fabrication, ce qui expose ainsi le fabricant de produits semi-conducteur à une proportion non négligeable de rebuts.

La structure dynamique est connue d'un homme du métier pour être sensible aux variations des procédés de fabrication et aux phénomènes de mismatch entre deux composants.

Il est donc souhaitable de bénéficier d'une nouvelle structure de bascule D, statique, robuste et large bande, utilisant des signaux d'entrée et de sortie pleine échelle, qui permet d'envisager des fréquences de fonctionnement élevée tout en réduisant le bruit de phase.

Tel est l'objet de la présente invention.

### Exposé de l'invention

La présente invention a pour but de proposer une structure de bascule de type D statique présentant une structure simple à réaliser, parfaitement différentielle et capable de fonctionner à une fréquence élevée.

Un autre but de la présente invention consiste à proposer une structure de bascule capable de fonctionner dans une large bande de fréquence.

Un troisième but de la présente invention consiste à réaliser une bascule D limitant la consommation de courant.

C'est un quatrième but de la présente invention que de fournir une structure de bascule présentant un bruit de phase limité car n'intégrant pas de résistance de charge.

C'est un cinquième but de la présente invention que de permettre la réalisation d'une bascule D avec une topologie parfaitement symétrique capable de gérer des signaux complémentaires en entrée et en sortie. Cette caractéristique favorise également un faible bruit de phase car le fonctionnement différentiel permet d'éliminer les harmoniques paires au niveau des signaux de sortie.

C'est enfin un autre but de la présente invention que de permettre la réalisation d'une bascule D robuste aux variations de procédés de fabrication dans l'industrie de la-micro-électronique.

L'invention réalise ces buts au moyen d'un circuit de bascule statique de type D, comportant :
- un premier circuit connecté entre un premier potentiel de référence et un second potentiel de référence, et comportant en outre, en série, un premier transistor, un second transistor et un troisième transistor ;
- un second circuit connecté entre le premier et le second potentiel, et comportant en outre en série un quatrième transistor, un cinquième transistor et un sixième transistor ;
- un troisième circuit comportant un septième transistor et un huitième transistor connectés en série entre, d'une part, le point de jonction du second transistor et du troisième transistor et, d'autre part, le point de jonction du cinquième transistor et du sixième transistor, ledit point de jonction des septième et huitième transistors étant connecté au potentiel Vdd.

La donnée D est transmise via une première entrée aux grilles des troisième et septième transistors, tandis que la donnée inverse est reçue via une seconde entrée et transmise aux grilles des sixième et huitième transistors.

Le signal d'horloge est transmis aux grilles des second et cinquième transistors qui jouent ainsi le rôle d'interrupteur permettant de faire « passer » l'information dans la partie supérieure de la bascule, composée des premier et quatrième transistors.

Le circuit génère en sortie le signal Q au niveau du point de jonction des premier et second transistors, point de jonction qui est également connecté à la grille du quatrième transistor.

Corrélativement, le signal inverse de Q est généré au au point de jonction des quatrième et cinquième transistors, qui est également connecté à la grille du premier transistor.

On constate que l'invention réalise un circuit simple de bascule statique de type D, comportant uniquement huit transistors de type MOS, et ne nécessitant aucune résistance de charge susceptible d'introduire un bruit de phase important. Par ailleurs, on pourra faire fonctionner le circuit à une fréquence très élevée, puisque le signal d'horloge sera transmis au second et quatrième transistor fonctionnant à grande vitesse.

Dans un mode de réalisation préféré, la tension Vdd est positive et les premier, quatrième, septième et huitième transistors sont de type PMOS tandis que lesdits second, troisième, cinquième et sixième transistors sont de type opposés, à savoir NMOS.

Alternativement, le potentiel Vdd est une valeur négative et les premier, quatrième, septième et huitième transistors sont de type NMOS tandis que lesdits second, troisième, cinquième et sixième transistors sont de type opposés, à savoir PMOS.

Dans un mode de réalisation préféré, on réalise les lesdits premier, second, troisième, quatrième, cinquième, sixième, septième et huitième transistors de taille similaire de manière à présenter une topologie parfaitement symétrique, tant au niveau horizontal que vertical.

Dans un mode de réalisation particulier, le circuit est utilisé pour réaliser un lien série fonctionnant à haute vitesse.

Dans un autre mode de réalisation, le circuit de bascule D sert à la réalisation d'un circuit de division de fréquence fonctionnant à haute vitesse.

Alternativement, le circuit peut servir à la réalisation d'un circuit générant quatre signaux d'horloge parfaitement en quadrature, à 0, 90, 180 et 270 degrés.

### Description des dessins

D'autres caractéristiques, buts et avantages de l'invention apparaîtront à la lecture de la description et des dessins ci-après, donnés uniquement à titre d'exemples non limitatifs. Sur les dessins annexés :
La figure 1 illustre la structure d'une bascule D statique réagissant sur front, ou flip-flop, classiquement connue.
La figure 2 représente une première structure bien connue de Bascule D de type Current Mode Logic (C.M.L.) statique adaptée à un fonctionnement en haute fréquence
La figure 3 illustre une seconde structure bien connue basée sur une bascule D CMOS dynamique.
La figure 4 illustre un mode de réalisation d'une bascule D CMOS - statique et haute fréquence - de l'invention.
La figure 5 illustre une première application possible de l'invention permettant la réalisation d'un circuit diviseur de fréquence basé sur une bascule D statique réagissant sur front *(D flip-flop),* constituée de deux bascules élémentaires D statiques réagissant sur niveau *(D latch*)*.*
La figure 6 illustre une seconde application possible de l'invention pour la réalisation d'un générateur de signaux en quadrature.

### Description d'un mode de réalisation préféré

On va décrire à présent une structure de bascule D conforme à la présente invention qui permet d'envisager un fonctionnement à haute fréquence tout en limitant le bruit de phase.

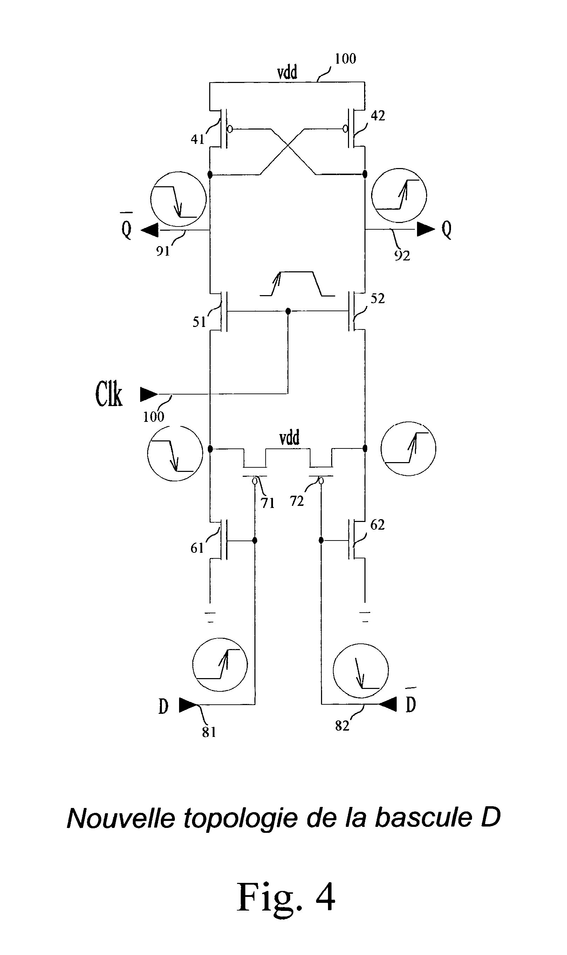

L'exemple va être particulièrement décrit pour un circuit présentant une tension d'alimentation Vdd positive, étant entendu qu'il sera facile d'envisager un circuit dual travaillant à une tension d'alimentation Vdd négative, en optant pour des transistors de type opposés à ceux que l'on voit dans la figure 4.

La bascule D de la figure 4 est basée sur une structure parfaitement symétrique comportant deux branches parallèles connectées entre un premier potentiel de référence (supposé être le potentiel d'alimentation positif Vdd de la figure) et un second potentiel de référence qui est la terre.

La première branche comporte en série un premier transistor de type MOS 41, un second transistor MOS 51 et un troisième MOS 61, tandis que la seconde branche comporte, en série, un quatrième troisième MOS 42, un cinquième transistor MOS 52 et un sixième transistor MOS 62.

Un septième transistor MOS 71 et un huitième transistor MOS 72 de même type sont connectés en série entre, d'une part, le point de jonction du second transistor 51 et du troisième transistor 61 et, d'autre part, le point de jonction du cinquième transistor 52 et du sixième transistor 62. Par ailleurs le point de jonction des septième et huitième transistors MOS 71 et 72 est connecté au premier potentiel de référence Vdd.

Les premier, quatrième, septième et huitième transistors MOS 41, 42, 71 et 72 sont d'un même type et également de type opposé aux transistors 51, 52, 61 et 62.

Dans le mode de réalisation de la figure 4 - nullement limitatif - la tension Vdd est supposée être positive, les transistors 41, 42, 71 et 72 sont des transistors de type PMOS tandis que les transistors 51, 52, 61 et 62 sont de type NMOS.

La donnée D est injectée, via une électrode 81 à la grille des transistors 61 et 71 et, inversement, l'inverse de la donnée D est injecté, comme on le voit sur la figure, aux grilles des transistors 62 et 72.

Le signal d'horloge CLK , injectée dans la bascule via une électrode 100, est transmis à la grille du second transistor 51 et sur la grille du cinquième transistor 52, lesquels jouent par conséquent le rôle d'interrupteurs.

Par ailleurs le point de jonction entre le transistor 41 (resp. 42) et le transistor 51 (resp. 52) est connecté à la grille du transistor 42 (resp. 41).

La bascule D comporte enfin une première sortie 92 générant la valeur Q, laquelle sortie est connectée au point de jonction des transistors 42 et 52, également connecté à la grille du transistor 41.

De la même manière, la bascule comporte une seconde sortie complémentaire 91 qui génère la valeur opposée de Q, et qui est connectée au point de jonction des transistors 41, 51 et à la grille du transistor 42.

Le fonctionnement de la bascule D selon la présente invention est le suivant :

Supposons que la donnée D (transmise à l'entrée 81) soit un « 1 » et corrélativement la donnée inverse D (transmise à l'entrée 82) soit un « 0 ». Ces deux valeurs sont injectées, respectivement à l'électrode commune des transistors 51 et 61 (à savoir la source du transistor 51 et le drain du transistor 61) d'une part et à l'électrode commune des transistors 52 et 62 avec du gain en raison de la présence des transistors PMOS 71 et 72.

Les valeurs de « 1 » et de « 0 » présentées aux électrodes 81 et 82 sont représentées par des fronts respectivement montants et descendants sur la figure 4.

Ces fronts respectivement montants et descendants se traduisant - avec un effet d'amplification - par des fronts respectivement descendants sur l'électrode de drain des transistors 61 et 62. En effet, l'amplification au niveau du front descendant présent sur le drain du transistor NMOS résulte de la présence de ce dernier tandis que l'amplification apparaissant sur le front montant du drain du transistor 62 provient de la présence du transistor PMOS 72. La symétrie du circuit assure par ailleurs une transmission simultanée des fronts au niveau de la source des transistors NMOS 51 et 52.

De ce fait, ce sont deux niveaux bien stables - respectivement un « 0 » et un « 1 » - qui sont transmis par les interrupteurs que forment les transistors 51 et 52 sur le front montant du coup d'horloge présenté sur l'électrode 100, et qui finalement apparaissent sur les drains, respectivement des transistors 41 et 42.

Ces niveaux étant également transmis aux grilles de ces mêmes transistors 41 et 42, l'information est alors maintenue dans la cellule mémoire même lorsque le signal d'horloge repasse à un niveau bas.

On constate par conséquent la simplicité du circuit qui réalise une bascule D statique, parfaitement symétrique et qui, en raison de l'absence de résistance de charge, assure un niveau de bruit plancher particulièrement bas.

Le circuit qui vient d'être décrit suppose que le potentiel Vdd est positif par rapport au second potentiel de référence (terre). Il est clair qu'un homme du métier pourra adapter directement l'enseignement de l'invention à un circuit dual dans lequel le potentiel Vdd serait négatif par rapport à la terre. Dans ce cas, de manière immédiate, on constate que le circuit de la figure 4 reste identique et l'on notera simplement que les transistors 41, 42, 71 et 72 seront de type NMOS tandis que les transistors 51, 61, 52 et 62 seront de type PMOS.

Par ailleurs, la bascule D qui vient d'être décrite autorise un fonctionnement en haute fréquence particulièrement remarquable. Elle permet d'envisager la réalisation de liens série à haute vitesse (High Speed Serial Link) pour une fréquence de 10 Ghz, tout en limitant le bruit de phase à une valeur remarquable, puisque les mesures ont montré une valeur de - 147 dBc/Hz à 1 Mhz. Comme on le voit, la bascule D conformément à la présente invention améliore l'immunité par rapport au bruit tout en autorisant - et cela est également remarquable - une consommation des plus limitées.

La bascule D qui vient d'être décrite peut servir à réaliser un grand nombre de combinaisons, et notamment la réalisation d'un flip-flop de type D.

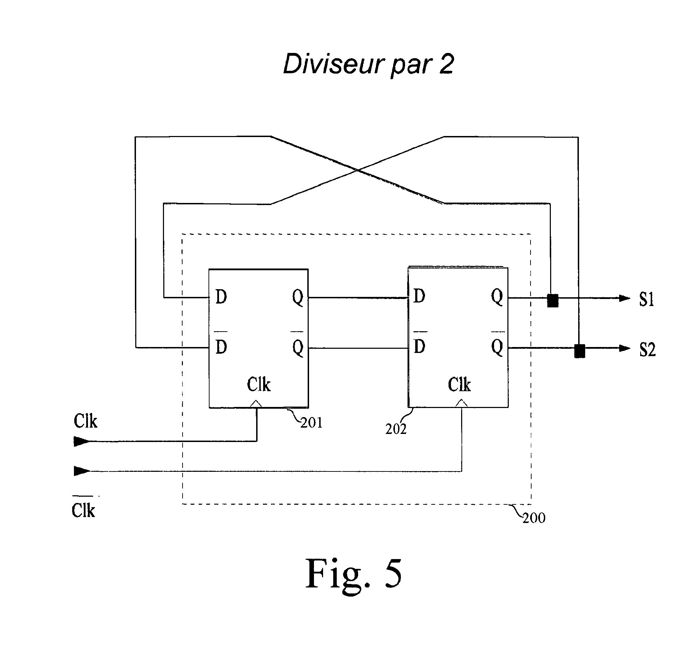

On voit également, en référence à la figure 5, qu'elle peut être utilisée pour réaliser un diviseur de fréquence 200, comportant deux bascules élémentaires 201 et 202 telles que décrites précédemment, qui permet de fonctionner à des fréquences élevées, et notamment à 10 Ghz.

Par ailleurs, on a observé que la bascule D de la présente invention présente une propriété remarquable. Les transistors de type PMOS n'ont pas besoin de commander de courants importants et, par suite, on peut les dimensionner de manière identique aux transistors NMOS. On peut ainsi réaliser très aisément une topologie semi-conducteur parfaitement symétrique, aussi bien sur un plan horizontal que vertical, dans laquelle tous les transistors sont parfaitement alignés.

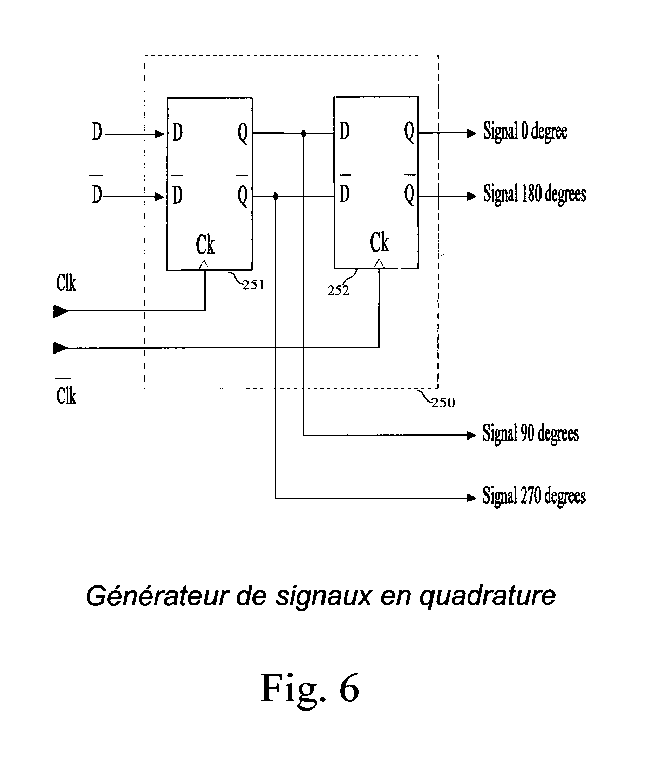

Cela contribue, une fois de plus, à la robustesse de fonctionnement et, en particulier, si l'on utilise la bascule pour la réalisation d'un circuit de quadrature comme celui que l'on voit dans la figure 6, on a constaté que ce circuit est parfaitement robuste et peu sensible aux erreurs de phase injectées en entrée. Les sorties 0, 90, 180 et 270 restent parfaitement en quadrature en dépit de la présence de déphasage sur les entrées.

## Revendications

1. Circuit de bascule statique de type D, comportant :
- un premier circuit connecté entre un premier potentiel de référence (Vdd) et un second potentiel de référence, ledit premier circuit comportant en série un premier transistor (41), un second transistor (51) et un troisième transistor (61) ;
- un second circuit connecté entre ledit premier potentiel de référence (Vdd) et ledit second potentiel de référence, ledit second circuit comportant en série un quatrième transistor (42), un cinquième transistor (52) et un sixième transistor (62) ;
- un troisième circuit comportant un septième transistor (71) et un huitième transistor (72) connectés en série entre, d'une part, le point de jonction dudit second transistor (51) et dudit troisième transistor (61) et, d'autre part, le point de jonction dudit cinquième transistor (52) et du sixième transistor (62), ledit point de jonction desdits septième transistor (71) et huitième transistor (72), étant connecté audit premier potentiel de référence (Vdd) ;
- une première entrée (81) destinée à recevoir la donnée vraie D, ladite première entrée étant connectée à la grille du troisième transistor (61) et à la grille du septième transistor (71) ;
- une seconde entrée (82) destinée à recevoir la donnée opposée D, ladite seconde entrée étant connectée à la grille du sixième transistor (62) et à la grille du huitième transistor (72) ;
- une troisième entrée (100) recevant le signal d'horloge, connectée aux grilles desdits deuxième transistor (51) et cinquième transistor (52) ;
- une première sortie (Q, 91) connectée au point de jonction desdits premier transistor (41) et second transistor (51), et également connecté à la grille dudit quatrième transistor (42) ;
- une seconde sortie (92) connectée au point de jonction dudit quatrième transistor (42) et dudit cinquième transistor (52), et également connecté à la grille dudit premier transistor (41).

2. Circuit de bascule statique D selon la revendication 1 **caractérisé en ce que** ledit premier potentiel de référence (Vdd) est positif par rapport audit second potentiel de référence **en ce que** les lesdits premier transistor (41), quatrième transistor (42), septième transistor (71) et huitième transistor (72) sont de type PMOS tandis que lesdits second, troisième, cinquième et sixième transistors (51, 61, 52, 62) sont de type NMOS.

3. Circuit de bascule statique D selon la revendication 1 **caractérisé en ce que** ledit premier potentiel de référence (Vdd) est négatif par rapport audit second potentiel de référence, et **en ce que** lesdits premier transistor (41), quatrième transistor (42), septième transistor (71) et huitième transistor (72) sont de type NMOS tandis que lesdits second, troisième, cinquième et sixième transistors (51, 61, 52, 62) sont de type PMOS.

4. Circuit de bascule statique D selon la revendication 1 **caractérisé en ce que** lesdits premier, second, troisième, quatrième, cinquième, sixième, septième et huitième transistors sont choisis de taille identique de manière à rendre complètement symétrique la topologie du circuit au sein du produit semi-conducteur.

5. Circuit de bascule statique D selon la revendication 1 **caractérisé en ce qu'**il est utilisé pour la réalisation d'un lien série fonctionnant à haute fréquence.

6. Circuit de bascules statiques D selon la revendication 1 **caractérisé en ce qu'**il est utilisé pour réaliser une bascule de type flip-flop D.

7. Circuit de division de fréquence comportant une cascade de deux circuits de bascules statiques D telles que définies dans l'une quelconque des revendications 1 à 6.

8. Circuit de quadrature de phase générant quatre signaux d'horloges en quadrature **caractérisé en ce qu'**il comporte deux circuits de bascules statiques D telles que définies dans l'une quelconque des revendications 1 à 6.
